# EUROPÄISCHE PATENTSCHRIFT

(11) **EP 1 829 107 B1**
(45) Veröffentlichungstag und Bekanntmachung des Hinweises auf die Patenterteilung: **07.05.2008**
(21) Anmeldenummer: 05813423.0
(22) Anmeldetag: 28.11.2005
(51) Int. Cl.: H01L 25/065, H01L 25/07

(54) **Anordnung eines Halbleitermoduls und einer elektrischen Verschienung**
Arrangement of a semiconductor module and an electrical busbar
Dispositif d'un module semi-conducteur et un ensemble de barres électriques

(30) Priorität: 22.12.2004 DE 102004061936
(43) Veröffentlichungstag der Anmeldung: 05.09.2007
(73) Patentinhaber: SIEMENS AKTIENGESELLSCHAFT, 80333 München (DE)
(72) Erfinder: SELIGER, Norbert, 85604 Zomeding (DE); NAGEL, Andreas, 90478 Nürnberg (DE); KNAAK, Hans-Joachim, 91054 Erlangen (DE); HOFSTETTER, Matthias, 91056 Erlangen (DE); BAKRAN, Mark-Matthias, 91052 Erlangen (DE); FUCHS, Andreas, 91056 Erlangen (DE)
(86) Internationale Anmeldenummer: PCT/EP2005/056257
(87) Internationale Veröffentlichungsnummer: WO 2006/067021

(56) Entgegenhaltungen:
- WO-A-03/030247
- US-A- 3 348 105
- US-A- 4 881 117
- US-A- 6 020 597

## Beschreibung

Die Erfindung betrifft eine Anordnung eines Halbleitermoduls und einer elektrischen Verschienung (Stromverschienung).

Das Halbleitermodul ist beispielsweise ein Halbleitermodul, bei dem mehrere Halbleiterbauelemente auf einem Substrat (Schaltungsträger, Trägerkörper) aufgebracht und in entsprechender Weise elektrisch verschaltet sind. Für eine interne Verbindung der Kontakte der Halbleiterbauelemente im Halbleitermodul werden Bonddrähte verwendet. Zur elektrischen Isolierung sind die Bonddrähte und die Halbleiterbauelemente in eine Vergussmasse eingegossen. Die Vergussmasse ist beispielsweise Silikon. Das vergossene Halbleitermodul ist in einem Gehäuse angeordnet. Das Gehäuse dient dem Schutz des Halbleitermoduls und fungiert gleichzeitig als Träger elektrischer (Last-)Anschlüsse. Die elektrischen Anschlüsse sind nach außen hin mit der elektrischen Verschienung elektrisch leitend verbunden. Die elektrische Verschienung weist eine Versorgungsstromschiene auf, über die eine Versorgungsspannung für einen der Kontakte des Halbleiterbauelements bereitgestellt wird.

Eine Alternative zur internen Verbindung der Kontakte mittels Bonddrähten ist aus der WO 03/030247 A2 bekannt. Dabei wird eine Kontaktfläche eines elektrischen Kontakts eines auf einem Substrat angeordneten Halbleiterbauelements großflächig und planar kontaktiert. Zur Kontaktierung wird eine Isolationsfolie auf das Halbleiterbauelement auflaminiert. Durch Erzeugen von Fenstern in der Isolationsfolie wird die Kontaktfläche des Halbleiterbauelements freigelegt und nachfolgend durch Metallabscheidung auf der Kontaktfläche und auf Bereichen der Isolationsfolie elektrisch kontaktiert.

Aufgabe der vorliegenden Erfindung ist es, eine einfache und kompakte Anordnung aus Halbleitermodul und elektrischer Verschienung des Halbleitermoduls anzugeben.

Zur Lösung der Aufgabe wird eine Anordnung mindestens eines Halbleitermoduls und mindestens einer elektrischen Verschienung angegeben, wobei das Halbleitermodul mindestens ein Substrat und mindestens ein auf dem Substrat angeordnetes Halbleiterbauelements mit einem elektrischen Kontakt und mindestens einem weiteren elektrischen Kontakt aufweist, die Verschienung mindestens eine Versorgungsstromschiene zum Bereitstellen einer Versorgungsspannung für den Kontakt des Halbleiterbauelements aufweist, und zur elektrischen Isolierung der Versorgungsstromschiene und des weiteren Kontakts des Halbleiterbauelements voneinander eine elektrische Isolationsfolie auf dem Halbleiterbauelement und/oder auf der Versorgungsstromschiene angeordnet ist.

Besonders vorteilhaft ist die Anordnung für Leistungshalbleitermodule. Daher sind gemäß einer besonderen Ausgestaltung das Halbleitermodul ein Leistungshalbleitermodul und das Halbleiterbauelement ein aus der Gruppe IGBT, Diode, MOSFET, Tyristor und/oder Bipolartransistor ausgewähltes Leistungshalbleiterbauelement.

Durch die Isolationsfolie kann auf zusätzliche Isolationsmaßnahmen, beispielsweise der Verguss mit Silikon, verzichtet werden. Die Versorgungsstromschiene ist nur mit dem zu kontaktierenden elektrischen Kontakt elektrisch leitend verbunden. Darüber hinaus kann auf das Gehäuse verzichtet werden. Das Halbleiterbauelement bzw. das Halbleitermodul mit mehreren Halbleiterbauelementen wird ungehäust mit der elektrischen Verschienung verbunden. Es resultiert eine im Vergleich zum Stand der Technik einfachere und kompaktere Anordnung.

Das Halbleiterbauelement ist vorzugsweise derart auf dem Substrat angeordnet, dass eine elektrische Kontaktfläche des Kontakts dem Substrat abgewandt ist. Über eine weitere Kontaktfläche des weiteren Kontakts ist das Halbleiterbauelement dem Substrat zugewandt. Beispielsweise ist das Halbleiterbauelement über die weitere Kontaktfläche auf das Substrat aufgelötet oder aufgeklebt.

In einer besonderen Ausgestaltung ist das Halbleiterbauelement auf einem Substrat angeordnet und die Isolationsfolie derart auf dem Halbleiterbauelement und dem Substrat aufgebracht, dass eine Oberflächenkontur des Halbleiterbauelement und/oder eine Oberflächenkontur des Substrats in einer Oberflächenkontur der Isolationsfolie abgebildet sind, die dem Halbleiterbauelement und/oder dem Substrat abgekehrt ist. Die Isolationsfolie kann dabei aufgeklebt sein. Vorzugsweise ist die Isolationsfolie auf das Halbleiterbauelement und auf das Substrat auflaminiert. Das Auflaminieren erfolgt vorzugsweise ohne Klebstoff. Die Isolationsfolie wird nicht aufgeklebt. Im Übrigen ist es auch möglich, eine Isolationsfolie zusätzlich oder alleine auf die Versorgungsstromschiene der elektrischen Verschienung aufzulaminieren oder aufzukleben.

Die elektrische Kontaktierung der Kontakte des Halbleiterbauelements des Halbleitermoduls erfolgt bevorzugt planar, also nicht über Bonddrähte. Dadurch kann die Isolationswirkung der Isolationsfolie voll ausgenutzt werden. Eine großflächige Kontaktierung ist möglich. Durch die planare Kontaktierung sind die Halbleiterbauelemente niederinduktiv kontaktiert. Mit der planaren Kontaktierung ist auch ein im Vergleich zu einer Kontaktierung mit Bonddrähten robusterer Aufbau zugänglich.

Im Folgenden wird die Erzeugung eines Halbleitermoduls mit elektrischer Isolationsfolie und planarer Kontaktierung der Kontakte der Halbleiterbauelemente des Halbleitermoduls näher beschreiben: Es sollen mehrere Halbleiterbauelemente auf einem Substrat zu einem Halbleitermodul zusammengefasst werden. Zum Herstellen des Halbleitermoduls wird beispielsweise ein DCB(Direct Copper Bonding)-Substrat bereitgestellt, auf dem die für das Halbleitermodul benötigten Halbleiterbauelemente mit Hilfe eines elektrisch leitenden Verbindungsmittels aufgebracht und in entsprechender Weise über elektrische Leiterbahnen elektrisch verschaltet werden. Das DCB-Substrat weist eine Trägerschicht aus Aluminiumoxid (Al₂O₃) oder Aluminiumnitrid (AlN) auf. Beidseitig sind elektrisch leitende Kupferschichten aufgebracht, die zu Leiterbahnen ausgestaltet sind. Das elektrisch leitfähige Verbindungsmittel ist beispielsweise ein Lot oder ein elektrisch leitfähiger Klebstoff. Die Halbleiterbauelemente werden aufgelötet oder aufgeklebt. Die Anwendung einer Niedertemperaturverbindungstechnik (NTV) ist ebenfalls denkbar. Mit den beschriebenen Verfahren werden die Halbleiterbauelemente nicht nur elektrisch kontaktiert, sie werden auch auf dem Substrat mechanisch fixiert. Denkbar ist auch, dass mit dem elektrisch leitfähigen Verbindungsmittel lediglich ein elektrischer Kontakt hergestellt wird. Es erfolgt keine mechanische Fixierung der Halbleiterbauelemente. Dies gelingt beispielsweise mit einer elektrisch leitfähigen Paste (Leitpaste).

Auf die auf das Substrat aufgebrachten Halbleiterbauelemente wird eine Isolationsfolie, beispielsweise eine Kunststofffolie mit Polyimid (Polyimidfolie), auflaminiert. Das Auflaminieren erfolgt beispielsweise unter Vakuum. Dazu wird beispielsweise eine Vakuumpresse verwendet. Durch das Auflaminieren unter Vakuum entsteht eine besonders feste und innige Verbindung zwischen den Halbleiterbauelementen und der Isolationsfolie bzw. zwischen dem Substrat und der Isolationsfolie. Gegebenfalls folgt dem Auflaminieren ein Temperaturbehandlungsschritt. Dies erhöht eine Stärke der Verbindung zwischen der Isolationsfolie und den Halbleiterbauelementen bzw. dem Substrat. Insbesondere bei Verwendung einer Leitpaste übernimmt die auflaminierte Isolationsfolie die Positionierung und/oder die mechanische Fixierung der Halbleiterbauelemente auf dem Substrat.

Nach dem Auflaminieren der Isolationsfolie werden die elektrisch zu kontaktierenden Kontakte der Halbleiterbauelemente freigelegt. Dazu wird beispielsweise ein Photolithographieverfahren durchgeführt. Alternativ dazu wird ein Laserablationsverfahren eingesetzt. Bei beiden angegebenen Verfahren wird durch Materialabtrag ein Fenster in der Isolationsfolie erzeugt. Der jeweilige Kontakt des jeweiligen Halbleiterbauelements wird durch das Fenster freigelegt. Nachfolgend wird elektrisch leitendes Material auf dem Kontakt abgeschieden. Zur Bildung elektrischer Leiterbahnen auf der Isolationsfolie wird das elektrisch leitende Material auch auf der Isolationsfolie abgeschieden. Das Abscheiden erfolgt aus einer Dampfphase und/oder flüssigen Phase. Zum Abscheiden aus der Dampfphase wird beispielsweise ein physikalisches (Physical Vapour Deposition, PVD) oder ein chemischen (Chemical Vapour Deposition, CVD) Dampfabscheideverfahren eingesetzt. Ein Abscheiden aus der flüssigen Phase erfolgt elektrolytisch. Es wird ein elektrolytisches Abscheiden durchgeführt. Einzelne Verfahrensschritte können dabei mehrmals durchgeführt werden, so dass benötigte Schichtdicken erzeugt werden. Ebenso können verschiedene Teilmetallisierungsschichten erzeugt werden, die unterschiedliche Funktionen übernehmen. Es resultiert ein Mehrschichtaufbau auf mit übereinander angeordneten Teilmetallisierungsschichten.

Um eine effiziente elektrische Isolierung mit Hilfe der Isolationsfolie zu erzielen, wird eine dafür notwendige Folienstärke (Foliendicke) der Isolationsfolie gewählt. Die notwendige Folienstärke hängt von verschiedenen Faktoren ab, beispielsweise vom Isolationsmaterial der Isolationsfolie oder von der Art der Halbleiterbauelemente. So sind Folienstärken von wenigen µm bis einigen hundert µm denkbar.

Um eine notwendige Isolationswirkung der Isolationsfolie zu erzielen, kann eine einzige, möglichst dicke Isolationsfolie auflaminiert werden. Eine entsprechende Isolationswirkung kann aber auch mit mehreren, übereinander gestapelten Teilisolationsfolien erzielt werden. Die Isolationsfolie weist einen Mehrschichtaufbau aus mindestens zwei übereinander angeordneten Teilisolationsfolien auf. Dadurch ist es möglich, eine effiziente Isolationswirkung auch bei einer relativ niedrigeren Gesamtfolienstärke der Isolationsfolie zu erzielen.

Gemäß einer besonderen Ausgestaltung ist die Anordnung eine Stromrichteranordnung mit einem Zwischenkreiskondensator und der Zwischenkreiskondensator über die Versorgungsstromschiene mit dem Halbleiterbauelement des Halbleitermoduls verbunden. Der Stromrichter setzt sich aus verschiedenen Komponenten (Bauelementen) zusammen. So weist der Stromrichter beispielsweise mehrere Leistungskomponenten auf. Eine Leistungskomponente des Stromrichters ist beispielsweise ein Leistungsschalter, der aus mehreren Leistungshalbleiterbauelementen zusammengesetzt ist. Eine weitere Leistungskomponente des Stromrichters ist beispielsweise ein Zwischenkreis bzw. ein Bestandteil des Zwischenkreises. Der Bestandteil des Zwischenkreises ist beispielsweise der Zwischenkreiskondensator. Je nach Stromrichtertopologie ist der Zwischenkreiskondensator unterschiedlich ausgestaltet. Beispielsweise ist der Zwischenkreiskondensator ein Elektrolytkondensator. Denkbar ist auch ein Zwischenkreiskondensator in Form eines Mehrschichtkondensators. Der Mehrschichtkondensator kann als separates Bauelement ausgeführt sein. Denkbar ist insbesondere auch, dass der Mehrschichtkondensator zusammen mit der Stromschiene ein Leistungsteil des Stromrichters bildet.

Das Halbleitermodul und die elektrische Verschienung können bleibend miteinander verbunden sein. Beispielsweise sind die die elektrische Verschienung und das Halbleitermodul miteinander verklebt oder verlötet. Beispielsweise wird ein elektrisch zu kontaktierender Kontakt des Halbleiterbauelements oder eine elektrische Verbindungsleitung des Halbleitermoduls mit der Versorgungsstromschiene verlötet oder verklebt. Das Halbleitermodul und die elektrische Verschienung können auch lösbar miteinander verbunden sein. Dies bedeutet, dass eine Verbindung zwischen dem Halbleitermodul und der elektrischen Verschienung bzw. zwischen einem der Kontakte eines Halbleiterbauelements und der Versorgungsstromschiene besteht, die zerstörungsfrei gelöst werden kann. Die lösbare Verbindung ist beispielsweise durch einen Druck-, Schraub- oder Steckkontakt realisiert. Der Druckkontakt wird beispielsweise mit Hilfe eines Federkontakts hergestellt.

In einer besonderen Ausgestaltung ist das Substrat des Halbleitermoduls mit einer Kühlvorrichtung thermisch leitend verbunden. Die Kühlvorrichtung kann derart ausgestaltet sein, dass ein Kühlfluid am Substrat vorbeigeleitet wird. Wenn das Substrat aus einem thermisch leitfähigen Material besteht, beispielsweise Aluminiumoxid oder Aluminiumnitrid, erfolgt eine effiziente Wärmeableitung von den Leistungshalbleiterbauelementen über das Substrat zum Kühlfluid der Kühlvorrichtung. Das Substrat selbst ist dabei Bestandteil der Kühlvorrichtung.

In einer besonderen Ausgestaltung ist die Kühlvorrichtung ein Kühlkörper. Beispielsweise ist das Substrat mit Hilfe eines thermisch leitfähigen Klebstoffs auf dem Kühlkörper aufgeklebt. Dadurch erfolgt eine effiziente Wärmeableitung von den Leistungshalbleiterbauelementen über das Substrat und über den Klebstoff hin zum Kühlkörper. Der Kühlkörper ist beispielsweise ein Aluminium- oder Kupferkörper, der mit Kühlrippen ausgestattet ist.

Das Halbleitermodul kann ein einziges Substrat mit mehreren Halbleiterbauelementen aufweisen. Vorzugsweise sind mehrere Versorgungsstromschienen zur elektrischen Kontaktierung der Kontakte der Halbleiterbauelemente vorhanden. Dabei kann eine Versorgungsstromschiene gleiche Kontakte mehrerer Halbleiterbauelemente mit der notwendigen elektrischen Spannung versorgen. Die Stromverschienung ist dabei derart ausgelegt, dass ein für den Betrieb der Halbleiterbauelemente des Halbleitermoduls notwendiger Stromfluss gewährleistet ist. Dies gilt insbesondere für ein Leistungshalbleitermodul.

In einer besonderen Ausgestaltung weist das Halbleitermodul mehrere Substrate mit jeweils mindestens einem Halbleiterbauelement mit einem Kontakt und mindestens einem weiteren Kontakt auf, wobei die Kontakte der Halbleiterbauelemente der Substrate mit einer Versorgungsstromschiene der Verschienung kontaktiert sind und die weiteren Kontakte der Halbleiterbauelemente und die Versorgungsstromschiene mit Hilfe jeweils einer auf dem jeweiligen Halbleiterbauelement angeordneten elektrischen Isolationsfolie elektrisch voneinander isoliert sind. Mit einer elektrischen Verschienung können somit die elektrischen Kontakte einer Vielzahl von Halbleiterbauelementen elektrisch kontaktiert werden, die sich auf einer Vielzahl von Substraten befinden können.

Zusammenfassend ergeben sich mit der vorliegenden Erfindung folgende wesentlichen Vorteile:
- Mit der Erfindung ist eine einfache und kompakte Anordnung aus Halbleitermodul und elektrischer Verschienung zugänglich.
- Durch die Verwendung von Isolationsfolien kann auf eine zusätzliche Isolierung durch Silikonverguss verzichtet werden.
- Ein Gehäuse zur Integration von elektrischen Anschlüssen, die mit einer externen elektrischen Verschienung verbunden werden müssen, ist nicht notwendig.

Anhand mehrerer Ausführungsbeispiele und der dazugehörigen Figuren wird die Erfindung im Folgenden näher beschrieben. Die Figuren sind schematisch und stellen keine maßstabsgetreuen Abbildungen dar.
- Figur 1: zeigt eine Anordnung mit mindestens eines Halbleitermoduls und einer elektrischen Verschienung in einem seitlichen Querschnitt.
- Figur 2: zeigt einen Ausschnitt der Anordnung gemäß Figur 1.
- Figur 3: zeigt einen weiteren Ausschnitt der Anordnung gemäß Figur 1.
- Figur 4: zeigt einen Ausschnitt einer weiteren Anordnung.

Gemäß dem ersten Ausführungsbeispiel liegt eine Anordnung 1 mit mehreren Halbleitermodulen 2 und einer elektrischen Verschienung 3 vor.

Die elektrische Verschienung 3 weist einen Mehrschichtaufbau auf. Die Verschienung 3 besteht aus einer Versorgungsstromschiene 31, einer weiteren Versorgungsstromschiene 32 und einer zwischen den Versorgungsstromschienen 31 und 32 angeordneten Isolationsschicht 33. Durch die Isolationsschicht 33 sind die beiden Versorgungsstromschienen 31 und 32 elektrisch voneinander isoliert. Sie können mit unterschiedlichen elektrischen Potentialen beaufschlagt werden.

Die Halbleitermodule 2 sind Leistungshalbleitermodule 23 weisen jeweils ein Substrat 6 auf, auf dem jeweils mindestens ein Halbleiterbauelement 21 aufgebracht ist. Die Halbleiterbauelemente 21 sind Leistungshalbleiterbauelemente 23 in Form von MOSFETs.

Die Substrate 6 der Leistungshalbleitermodule 23 sind DCB-Substrate. Jedes der DCB-Substrate 6 besteht aus einer Trägerschicht 61 aus Aluminiumoxid und beidseitig aufgebrachte elektrische Leistungsschichten 62 und 63 aus Kupfer. Die Leitungsschicht 62, auf die die Halbleiterbauelemente 22 aufgelötet sind, ist zu entsprechenden Leitungsbahnen strukturiert.

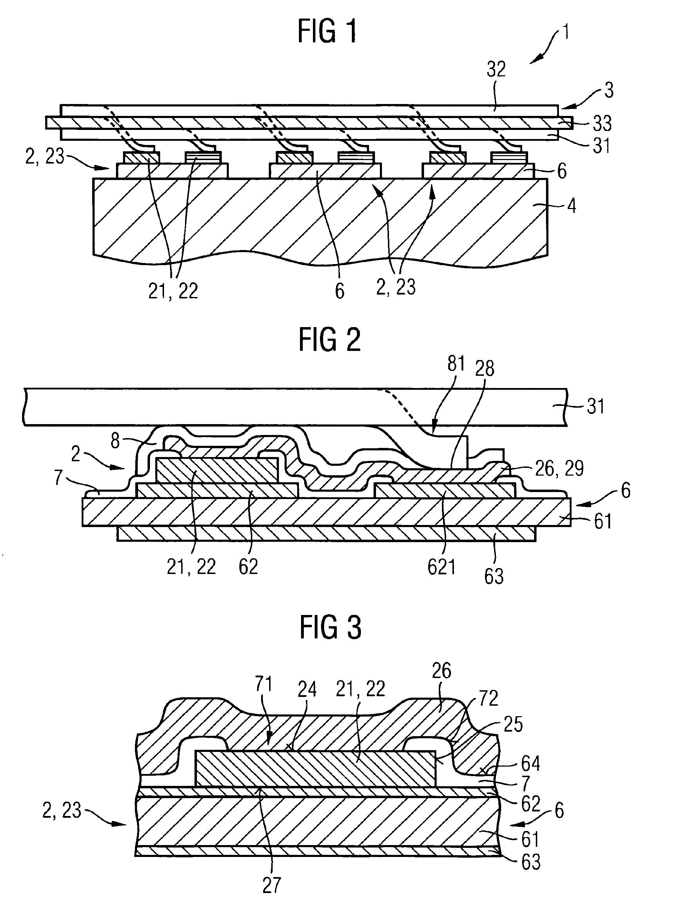

Jedes der Leistungshalbleiterbauelemente 22 ist derart aufgelötet, dass eine vom Substrat 6 wegweisende Kontaktfläche 24 des Leitungshalbleiterbauelements 22 resultiert (Figur 3). Dazu sind die Leistungshalbleiterbauelemente 22 über jeweils eine weitere Kontaktfläche 27 eines weiteren Kontakts, beispielsweise des Drain-Kontakts eines MOSFETs, auf die Leitungsschicht 62 aufgelötet. In alternativen Ausführungsformen sind die Leistungshalbleiterbauelemente 22 aufgeklebt, mittels Niedertemperaturverbindungstechnik verbunden oder mittels einer Leitpaste lediglich elektrisch kontaktiert, also nicht mechanisch fixiert.

Zur großflächigen, planaren elektrischen Kontaktierung der Kontaktfläche 24 des Leistungshalbleiterbauelements 22, beispielsweise des Source-Kontakts eines MOSFETs, ist eine Isolationsfolie 7 unter Vakuum auflaminiert. Die Isolationsfolie 7 ist dabei derart auf dem Substrat 6 und dem Leistungshalbleiterbauelementen 22 auflaminiert, dass eine Oberflächenkontur 25 des Leistungshalbleiterbauelements 22 und eine Oberflächenkontur 64 des Substrats 6 in einer Oberflächenkontur 72 der Isolationsfolie 7 abgebildet ist, die dem Substrat 6 und dem Leistungshalbleiterbauelement 22 abgekehrt ist. Bei Verwendung einer Leitpaste erfolgt die mechanische Fixierung des Leistungshalbleiterbauelements 22 auf dem Substrat 6 durch die auflaminierte Isolationsfolie 7. Durch Öffnen eines Fensters 71 in der Isolationsfolie 7 ist der Kontakt bzw. die Kontaktfläche 24 des Leistungshalbleiterbauelements 22 freigelegt. Das Öffnen des Fensters 71 erfolgt durch Laserablation. Die planare elektrische Kontaktierung der Kontaktfläche 24 wird durch eine mehrschichtige Abscheidung 26 von elektrisch leitendem Material erzeugt.

Durch die planare Kontaktierung der Leistungshalbleiterbauelemente 22 des Leistungshalbleitermoduls 23 durch die Verwendung der Isolationsfolie 7 ist gewährleistet, dass die Kontaktflächen 24 der Leitungshalbleiterbauelemente 22 elektrisch mit Hilfe einer Versorgungsstromschiene 31 der elektrischen Verschienung 3 kontaktiert werden. Gleichzeitig sind die weiteren Kontaktflächen 27 der Leistungshalbleiterbauelemente 23 von der Versorgungsschiene 31 der elektrischen Verschienung 3 elektrisch isoliert. Die weiteren Kontaktflächen 27 sind mit einer weiteren Versorgungsstromschiene 32 der elektrischen Verschienung 3 elektrisch kontaktiert. Zur kontrollierten elektrischen Kontaktierung ist auf die Abscheidung 26 eine weitere Isolationsfolie 8 auflaminiert. Die weitere Isolationsfolie 8 verfügt über ein weiteres Fenster 81, durch die die Kontaktierung der Abscheidung 26 mit der Versorgungsstromschiene 31 erfolgt.

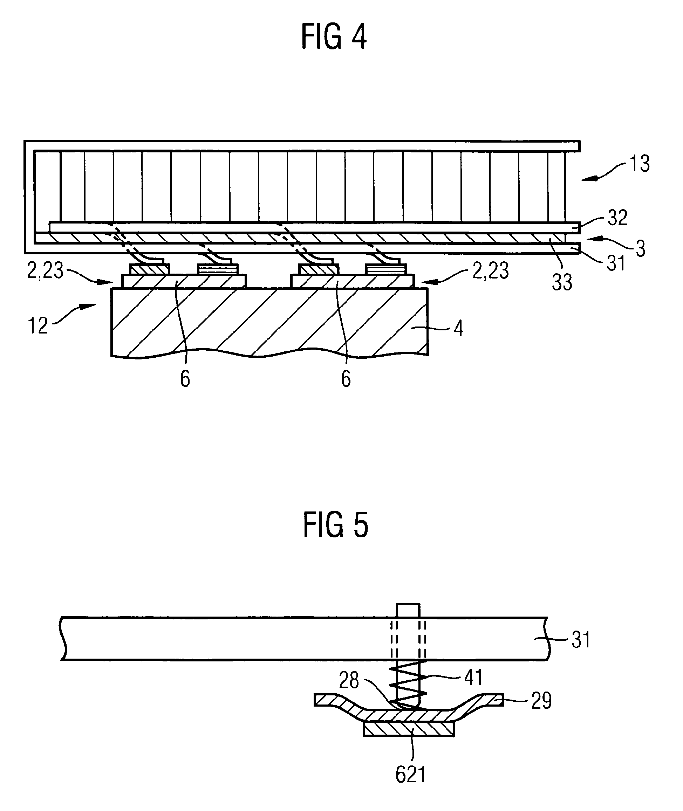

Zur elektrischen Kontaktierung der Kontaktfläche 24 eines Leistungshalbleiterbauelements 22 ist die Versorgungsstromschiene 31 der elektrischen Verschienung 3 mit einer Kontaktstelle 28 des Leistungshalbleitermoduls elektrisch leitend verbunden. Die Kontaktstelle 28 wird von einer auf das Substrat 6 bzw. auf einer Leiterschicht 621 aus Kupfer aufgebrachten elektrischen Verbindungsleitung 29 bereitgestellt. Die Leiterschicht 621 und die Leiterschicht 62, über die der weitere Kontakt 27 des Leistungshalbleiterbauelements 22 kontaktiert ist, sind elektrisch voneinander isoliert. Die Verbindungsleitung 29 weist die Metallabscheidung 26 zur elektrischen Kontaktierung der Kontaktfläche 24 des Leistungshalbleiterbauelements 22 auf. Die Versorgungsstromschiene 31 und die Verbindungsleitung 29 sind an der Kontaktstelle 28 miteinander verlötet (Figur 2). Alternativ dazu sind die Versorgungsstromschiene 31 und die Verbindungsleitung mit Hilfe eines lösbaren Federkontakts 41 elektrisch leitend miteinander verbunden (Figur 5).

Zur Kühlung der Anordnung 1 sind die Leistungshalbleitermodule 23 auf einem gemeinsamen Kühlkörper 4 aufgebracht. Gemäß einer ersten Ausführungsform sind die Leistungshalbleitermodule 23 jeweils über die weitere Leitungsschicht 63 der DCB-Substrate 6 aufgelötet. Alternativ dazu sind die Leistungshalbleitermodule mit Hilfe eines thermisch leitfähigen Leitklebers auf dem Kühlkörper fixiert.

Gemäß einem weiteren Ausführungsbeispiel ist die Anordnung 1 eine Stromrichteranordnung 11 (Figur 4). Die Stromrichteranordnung weist neben den Leistungshalbleitermodulen 23, mit deren Hilfe eine Leistungsschaltung 12 realisiert ist, einen Zwischenkreiskondensator 13 auf. Der Zwischenkreiskondensator 13 ist mit der Verschienung 3 verbunden und stellt zusammen mit der Verschienung 3 ein Leistungsteil der Stromrichteranordnung dar. Der Zwischenkreiskondensator 13 ist ein Mehrschichtkondensator.

## Patentansprüche

1. Anordnung (1) mindestens eines Halbleitermoduls (2, 23) und mindestens einer elektrischen Verschienung (3), wobei
- das Halbleitermodul (2) mindestens ein Substrat (6) und mindestens ein auf dem Substrat (6) angeordnetes Halbleiterbauelement (21, 22) mit einem elektrischen Kontakt (24) und mindestens einem weiteren elektrischen Kontakt (27) aufweist,
- die Verschienung (3) mindestens eine Versorgungsstromschiene (31) zum Bereitstellen einer Versorgungsspannung für den Kontakt (24) des Halbleiterbauelements (21) aufweist, und
- zur elektrischen Isolierung der Versorgungsstromschiene (31) und des weiteren Kontakts (27) des Halbleiterbauelements (21, 22) voneinander eine elektrische Isolationsfolie (7) auf dem Halbleiterbauelement (21, 22) und/oder auf der Versorgungsstromschiene (31) angeordnet ist.

2. Anordnung nach Anspruch 1, wobei das Halbleiterbauelement (21, 22) derart auf dem Substrat (6) angeordnet ist, dass eine elektrische Kontaktfläche des Kontakts (24) dem Substrat (6) abgewandt ist.

3. Anordnung nach Anspruch 1 oder 2, wobei die Isolationsfolie (7) derart auf dem Halbleiterbauelement (22) und dem Substrat (6) aufgebracht ist, dass eine Oberflächenkontur (25) des Halbleiterbauelements (21, 22) und/oder eine Oberflächenkontur (64) des Substrats (6) in einer Oberflächenkontur (72) der Isolationsfolie (7) abgebildet sind, die dem Halbleiterbauelement (21, 22) und/oder dem Substrat (6) abgekehrt ist.

4. Anordnung nach einem der Ansprüche 1 bis 3, wobei die Isolationsfolie (7) auf dem Halbleiterbauelement (21, 22) und/oder auf der Versorgungsstromschiene (31) auflaminiert ist.

5. Anordnung nach einem der Ansprüche 1 bis 4, wobei das Halbleiterbauelement (21, 22) durch die Isolationsfolie (7) auf dem Substrat (6) fixiert ist.

6. Anordnung nach einem der Ansprüche 1 bis 5, wobei das Halbleitermodul (2) ein Leistungshalbleitermodul (23) und das Halbleiterbauelement (21) ein aus der Gruppe IGBT, Diode, MOSFET, Tyristor und/oder Bipolartransistor ausgewähltes Leistungshalbleiterbauelement (22) sind.

7. Anordnung nach Anspruch 6, wobei die Anordnung (1) eine Stromrichteranordnung (11) mit einem Zwischenkreiskondensator (13) ist und der Zwischenkreiskondensator (13) über die Versorgungsstromschiene (31) mit dem Leistungshalbleiterbauelement (22) des Leistungshalbleitermoduls 23 verbunden ist.

8. Anordnung nach einem der Ansprüche 1 bis 7, wobei das Halbleitermodul (2) und die Versorgungsstromschiene (31) lösbar miteinander verbunden sind.

9. Anordnung nach einem der Ansprüche 2 bis 9, wobei das Substrat (6) des Halbleitermoduls mit einer Kühlvorrichtung (4) thermisch leitend verbunden ist.

10. Anordnung nach einem der Ansprüche 1 bis 9, wobei
- das Halbleitermodul (2) mehrere Substrate (6) mit jeweils mindestens einem Halbleiterbauelement (21, 22) mit einem Kontakt (24) und mindestens einem weiteren Kontakt (27) aufweist,
- die Kontakte (24) der Halbleiterbauelemente (21, 22) der Substrate (6) mit einer Versorgungsstromschiene (31) der Verschienung (3) kontaktiert sind und
- die weiteren Kontakte (27) der Halbleiterbauelemente (21, 22) und die Versorgungsstromschiene (31) mit Hilfe jeweils einer auf dem jeweiligen Halbleiterbauelement (21, 22) angeordneten elektrischen Isolationsfolie (7) elektrisch voneinander isoliert sind.

## Claims

1. Arrangement (1) of at least one semiconductor module (2, 23) and at least one electrical busbar system (3),
wherein
- the semiconductor module (2) has at least one substrate (6) and at least one semiconductor component (21, 22) arranged on the substrate (6) with an electrical contact (24) and at least one further electrical contact (27),
- the busbar system (3) has at least one supply busbar (31) to supply a supply voltage for the contact (24) of the semiconductor component (21) and
- for electrical insulation of the supply busbar (31) and the further contact (27) of the semiconductor component (21, 22) from each other, an electrical insulation film (7) is arranged on the semiconductor component (21, 22) and/or on the supply busbar (31).

2. Arrangement according to claim 1, wherein the semiconductor component (21, 22) is arranged on the substrate (6) in such a manner that an electrical contact surface of the contact (24) is turned away from the substrate (6).

3. Arrangement according to claim 1 or 2, wherein the insulation film (7) is arranged on the semiconductor component (22) and the substrate (6) in such a manner that a surface contour (25) of the semiconductor component (21, 22) and/or a surface contour (64) of the substrate (6) is mapped in a surface contour (72) of the insulation film (7) turned away from the semiconductor component (21, 22) and/or the substrate (6).

4. Arrangement according to one of claims 1 to 3, wherein the insulation film (7) is laminated onto the semiconductor component (21, 22) and/or onto the supply busbar (31).

5. Arrangement according to one of claims 1 to 4, wherein the semiconductor component (21, 22) is fixed to the substrate (6) by the insulation film (7).

6. Arrangement according to one of claims 1 to 5, wherein the semiconductor module (2) is a power semiconductor module (23) and the semiconductor component (21) is a power semiconductor component (22) selected from the group comprising IGBT, diode, MOSFET, thyristor and/or bipolar transistor.

7. Arrangement according to claim 6, wherein the arrangement (1) is a converter arrangement (11) with an intermediate circuit capacitor (13) and the intermediate circuit capacitor (13) is connected by way of the supply busbar (31) to the power semiconductor component (22) of the power semiconductor module 23.

8. Arrangement according to one of claims 1 to 7, wherein the semiconductor module (2) and the supply busbar (31) are connected to each other in a releasable manner.

9. Arrangement according to one of claims 2 to 9, wherein the substrate (6) of the semiconductor module is connected in a thermally conducting manner to a cooling device (4).

10. Arrangement according to one of claims 1 to 9, wherein
- the semiconductor module (2) has a number of substrates (6) each with at least one semiconductor component (21, 22) with a contact (24) and at least one further contact (27),
- the contacts (24) of the semiconductor components (21, 22) of the substrates (6) are contacted with a supply busbar (31) of the busbar system (3) and
- the further contacts (27) of the semiconductor components (21, 22) and the supply busbar (31) are insulated electrically from each other with the aid respectively of an electrical insulation film (7) arranged on the respective semiconductor component (21, 22).

## Revendications

1. Agencement (1) d'au moins un module (2, 23) à semi-conducteurs et d'au moins un ensemble (3) de barres électriques, dans lequel
- le module (2) à semi-conducteurs a au moins un substrat (6) et au moins un composant (21, 22) à semi-conducteurs qui est disposé sur le substrat (6) et qui a un contact (24) électrique et au moins un autre contact (27) électrique,
- l'ensemble (3) de barres a au moins une barre (31) de courant d'alimentation pour appliquer une tension d'alimentation au contact (24) du composant (21) à semi-conducteurs, et
- pour isoler électriquement la barre (31) de courant d'alimentation et l'autre contact (27) du composant (21, 22) à semi-conducteurs l'un de l'autre, une feuille (7) isolante électriquement est disposée sur le composant (21, 22) à semi-conducteurs et/ou sur la barre (31) de courant d'alimentation.

2. Agencement suivant la revendication 1, dans lequel le composant (21, 22) à semi-conducteurs est disposé sur le substrat (6) de façon à ce qu'une surface électrique du contact (4) soit éloignée du substrat (6).

3. Agencement suivant la revendication 1 ou 2, dans lequel la feuille (7) isolante est déposée sur le composant (22) à semi-conducteurs et sur le substrat (6) de façon à ce qu'un contour (25) de la surface du composant (21, 22) à semi-conducteurs et/ou un contour (64) de la surface du substrat (6) soit reproduit dans un contour (72) de la surface de la feuille (7) isolante, qui est éloigné du composant (21, 22) à semi-conducteurs et/ou du substrat (6).

4. Agencement suivant l'une des revendications 1 à 3, dans lequel la feuille (7) isolante est laminée sur le composant (21, 22) à semi-conducteurs et/ou sur la barre (31) de courant d'alimentation.

5. Agencement suivant l'une des revendications 1 à 4, dans lequel le composant (21, 22) à semi-conducteurs est immobilisé sur le substrat (6) par la feuille (7) isolante.

6. Agencement suivant l'une des revendications 1 à 5, dans lequel le module (2) à semi-conducteurs est un module (23) à semi-conducteurs de puissance et le composant (21) à semi-conducteurs est un composant (22) à semi-conducteurs de puissance choisi dans le groupe IGBT, diode, MOSFET, thyristor et/ou transistor bipolaire.

7. Agencement suivant la revendication 6, dans lequel l'agencement (1) est un agencement (11) de convertisseur ayant un condensateur de circuit (13) intermédiaire et le condensateur de circuit (13) intermédiaire est relié au composant (22) à semi-conducteurs de puissance du module (23) à semi-conducteurs de puissance par la barre (31) de courant d'alimentation.

8. Agencement suivant l'une des revendications 1 à 7, dans lequel le module (2) à semi-conducteurs et la barre (31) de courant d'alimentation sont reliés entre eux de manière amovible.

9. Agencement suivant l'une des revendications 2 à 8, dans lequel le substrat (6) du module à semi-conducteurs est relié d'une manière conductrice thermiquement à un dispositif (4) de refroidissement.

10. Agencement suivant l'une des revendications 1 à 9, dans lequel
- le module (2) à semi-conducteurs a plusieurs substrats (6) ayant respectivement au moins un composant (21, 22) ayant un contact (24) et au moins un autre contact (27),
- les contacts (24) des composants (21, 22) à semi-conducteurs du substrat (6) sont mis en contact avec une barre (31) de courant d'alimentation de l'ensemble de barres, et
- les autres contacts (27) des composants (21, 22) à semi-conducteurs et la barre (31) de courant d'alimentation sont isolés électriquement les uns des autres à l'aide de respectivement une feuille (7) isolante du point de vue électrique disposée sur le composant (21, 22) à semi-conducteurs respectif.
